# EUROPEAN PATENT SPECIFICATION

(11) **EP 1 198 717 B1**
(45) Date of publication and mention of the grant of the patent: **09.08.2006**
(21) Application number: 00916700.8
(22) Date of filing: 12.04.2000
(51) Int. Cl.: G01R 31/02, G01R 33/06, G01R 15/20

(54) **APPARATUS AND METHOD FOR FAULT DETECTION ON CONDUCTORS**
VORRICHTUNG UND VERFAHREN ZUR FEHLERDETEKTION IN LEITERN
APPAREIL ET PROCEDE DE DETECTION DE DEFAUTS DANS DES CONDUCTEURS

(30) Priority: 12.04.1999 US 128746 P
(43) Date of publication of application: 24.04.2002
(73) Proprietor: CHK Wireless Technologies Australia Pty Limited, Ermington, NSW 2115 (CH)
(72) Inventor: MCCAULEY, Simon, Francis, Newcastle, NSW 2300 (AU); SWEETING, David, Keith, St Ives, NSW 2075 (AU)
(74) Representative: Zech, Stefan Markus
(86) International application number: PCT/AU2000/000314
(87) International publication number: WO 2000/062083

(56) References cited:
- WO-A-89/09411
- WO-A-90/11529
- DE-A- 3 119 925
- GB-A- 2 140 564
- US-A- 3 882 287
- US-A- 4 408 155
- US-A- 5 250 894
- US-A- 5 434 509
- US-A- 5 530 363
- US-A- 5 565 783
- US-A- 5 825 598
- CRADDOCK ET AL.: 'The design and application of a permanent fault-passage indicator' INT. CONF. ON LIGHTNING AND POWER SYSTEMS IEE OPI, 1984, pages 188 - 192, XP002908760

## Description

### Field of the Invention

This invention relates broadly to a method and an apparatus for detecting faults on any one of a plurality of adjacent conductors utilising magnetic field measurements. The invention will be described herein with reference to fault indicators for overland power distribution cables, it will be appreciated, however, that the invention does have broader applications for various conductor arrangements in which faults may be experienced.

### Background of the Invention

Equipment for detection and location of faults on a plurality of overland power distribution cables involves typically the measurement of the magnetic field produced by the alternating currents flowing in the cables, using a single magnetic field sensing coil. Such equipment derives a signal indicative of the average magnetic field, and this is used for the detection and location of faults. When one or more of the cables experience a fault, high currents flow in the cables, producing a rapid increase in the magnetic field around the cables. Therefore, if an increase is detected by the equipment, this is indicative of a fault current in one or more of the cables having passed the magnetic field sensing coil.

However, the applicant has found that the use of a single coil has the disadvantage that there is usually at least one set of fault currents for a given cable configuration that will produce a change in the magnetic field around the cables that is not detectable by the single coil. This is because a single coil measurement cannot be utilised to monitor changes in the magnetic field that vary the relevant magnetic field vector at the point of the measurements in a direction perpendicular to the central axis of the coil.

US-A-4 408 155 discloses in a fault detector for an electrical transmission system having a conductor through which an alternating current flows and a sensor for monitoring the current flowing through said conductor, said sensor having an AC output signal proportional to the current and having positive and negative half cycles, an improved means for detecting a fault within one quarter of a fault current cycle, comprising (i) a high signal selecting means for selecting the positive half cycle of said sensor signal, (ii) means for comparing the signal selected by said high signal selector to a first reference signal, (iii) a low signal selecting means for selecting the negative half cycle of said sensor signal, (iv) means for comparing the signal selected by said low signal selector to a second reference signal, and (v) means for providing fault indication signal if the signal selected by said high signal selector exceeds said first reference signal or if the signal selected by said high signal selector is less than said second reference signal.

In US-A-5 565 783 a line-mounted fault detector for monitoring at least two operating parameters of an AC power transmission or distribution line and deriving information concerning faults occuring on the line is disclosed, comprising (i) first and second sensors, connectable in proximity to the transmission or distribution line, for providing at least two analog signals each representative to a time varying value of one of said at least two operating parameters, (ii) an analog-to-digital converter connected to said first and second sensors for sampling said at least two analog signals and producing corresponding digital signals, (iii) a processor responsive to said digital signals for detecting an abnormal condition and thereafter distinguishing whether any of a plurality of types of faults has occurred, and if so which of the plurality of types of faults occurred, and (iv) a transmitter responsive to said processor for, if any of the plurality of types of faults occurred, transmitting to a remote location information identifying which the plurality of types of faults occurred.

Furthermore, US-A-5 530 363 discloses an apparatus and a method for locating ground faults in a normally ungrounded DC circuit having a positive and a negative supply bus, said apparatus comprising a centertapped resistive voltage divider connected across said supply buses, means connecting and disconnecting said centertap and ground for alternatingly connecting and disconnecting said centertap to and from ground at a predetermined rate, and means for detecting the presence of current perturbations at selectable locations in conductors of said circuit which perturbations occur at said predetermined rate, said means for detecting current perturbations comprising a clamp-on Hall probe, as a clamp-on magnetic field probe, having an output coupled to an indicating device, and an automatically operative magnetic field cancelling device coupled to said probe, whereby at least as little as 5 mA ground fault current flowing through said buses is detectable.

Moreover, in WO 90/11529 A an apparatus and a method for measuring the electric current in current conductors in conditions of high interference in order control, for instance, an overcurrent trip relay is disclosed. The apparatus comprises single Hall-effect sensor(s) placed very close to each current conductor and voltage-measuring element(s) connected to each Hall sensor so that the measurement signal from the element can be used for computing the current level. Each current conductor is enclosed by an essentially U-shaped, or alternatively, comb-shaped core opening toward the Hall sensor and enclosing each sensor.

### Summary of the Invention

In accordance with a first aspect of the present invention there is provided a method of detecting for a fault on one of a plurality of adjacent, alternating current carrying conductors; the method comprising the steps of detecting the waveform of a first component of a magnetic field vector representative of the magnetic field around the plurality of conductors at a location along the conductors, detecting the waveform of a second ( i.e., angularly displaced) component of the magnetic field vector; monitoring, at the location, the two waveforms over a continuous time interval for any changes in the waveforms; and detecting for a fault on one of the plurality of the conductors as indicated by a change over the continuous time interval in either one or both of the waveforms.

Preferably, the method further comprises the step of determining whether the fault experienced is a phase to phase or a phase to earth fault as indicated by a change in both waveforms.

In one embodiment, the first and second components are at 90° with respect to each other.

Advantageously, the first component is the horizontal component of the magnetic field vector and the second component is the vertical component of the magnetic field vector.

In one embodiment, the step of monitoring the two waveforms comprises the steps of monitoring a first amplitude of the first waveform over a period of the alternating current, and monitoring a second amplitude of the second waveform over the period, and the step of detecting for a fault comprises detecting for the fault as indicated by a change in either one or both of the amplitudes.

Preferably, the step of monitoring the two waveforms comprises the step of monitoring a phase difference between the first and second waveforms, and the step of detecting for a fault comprises detecting for the fault as indicated by a change in the phase difference.

In accordance with a second aspect of the present invention there is provided an apparatus for detecting for a fault on one of a plurality of adjacent, alternating current carrying conductors, the apparatus comprising first detecting means for detecting the waveform of a first component of a magnetic field vector representing the magnetic field around the plurality of conductors at a location along the conductors; second detecting means for detecting the waveform of a second (i.e., angularly displaced) component of the magnetic field vector; monitoring means for monitoring the two waveforms over a continuous time interval for any changes in the waveforms; and a detecting unit arranged to generate a fault indication signal depending on a change over the continuous time interval in either one or both of the waveforms.

Preferably, the detecting unit is further arranged to determine whether the fault experienced is a phase to phase or phase to earth fault depending on reference data stored in a database of the apparatus.

In one embodiment, the monitoring unit is arranged to monitor a first amplitude of the first waveform over a period of the alternating current, and to monitor a second amplitude of the second waveform over the period, and the detecting unit generates a fault indication signal depending on a change in either one or both of the amplitudes.

Preferably, the monitor unit is further arranged to monitor a phase difference between the first and second waveforms and the detecting unit is further arranged to generate the fault indication signal depending on changes in the phase difference.

The present invention may be more readily understood from the description of preferred forms of an apparatus for electrical measurements on conductors given below with reference to the accompanying drawings.

### Brief Description of the Drawings

Figure 1 is a schematic diagram illustrating a set of three conductors mounted on a pole. The earth acts as a fourth conductor during earth faults.
Figure 2 is a graph illustrating the changes of a magnetic field vector produced at point A of Figure 1 for a balanced three phase set of currents flowing in the conductors.
Figure 3 is a graph illustrating the changes in the magnetic field vector for a 50 ampere earth fault on phase 1 of the set of currents of Figure 2.
Figure 4 is a graph illustrating the changes of the magnetic field vector for a 50 ampere earth fault on phase 2 of the set of currents of Figure 2.
Figure 5 is a graph illustrating the changes in the magnetic field vector for a 50 ampere phase to phase fault on phases 1 and 3 of the set of currents of Figure 2.
Figure 6 is a schematic diagram illustrating the use of an apparatus for detecting faults on a plurality of conductors in accordance with one embodiment of the present invention.

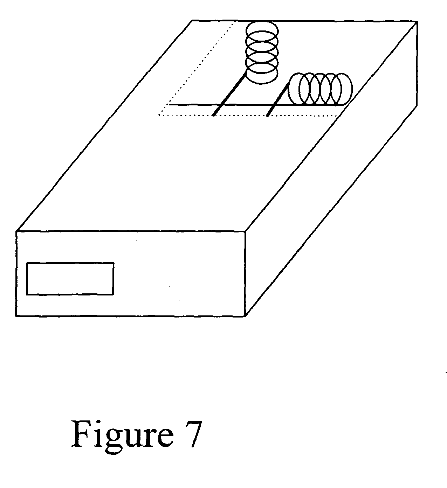

Figure 7 is a perspective view of the apparatus in Figure 6.

### Detailed Description of the Preferred Embodiment

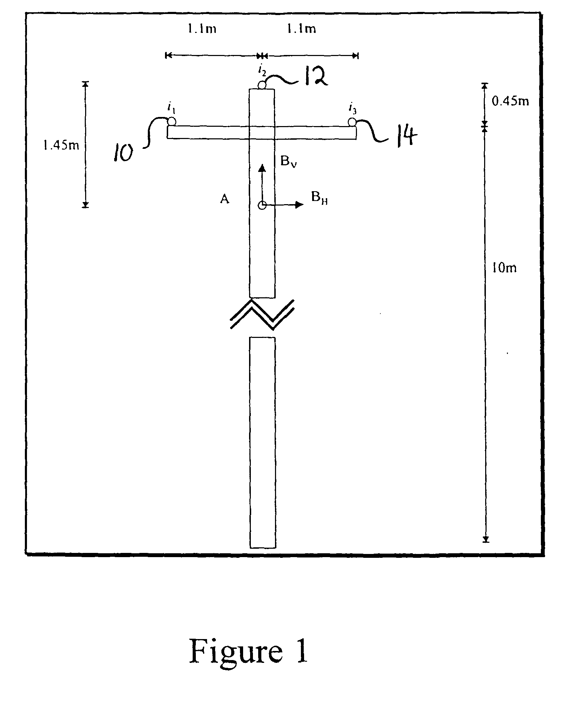

In Figure 1, the conductors 10, 12 and 14 carry currents *i*₁, *i*₂ and *i*₃, and the earth carries any imbalance. The magnetic field vector at a point A on the pole has horizontal and vertical components B_{H} and B_{V}.

At point A, the magnetic field vector follows an elliptical shape over the period of the sinewave. The shape of the ellipse varies depending on the amplitudes and phases of the currents *i*₁, *i*₂ and *i*₃.

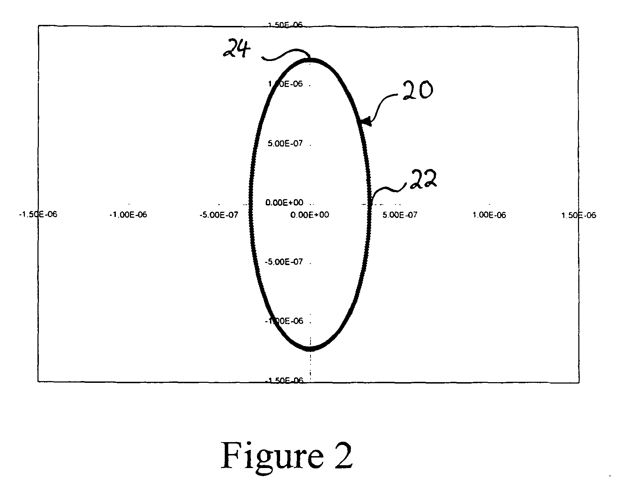

The ellipse of magnetic fields produced by four sets of currents is shown in Figures 2 to 5.

Turning to Figure 2, the graph 20 shows the ellipse of magnetic fields produced by a balanced set of three phase magnetic fields produced by a balanced set of three phase currents, with amplitude equal to 5 ampere:
*i*₁=5cos(wt) *i*₂=5cos(wt-2π/3) *i*₃=5cos(wt-4π/3) Bₓₘₐₓ, 22 = 0.33µT, B_{ymax}, 24 = 1.22µT

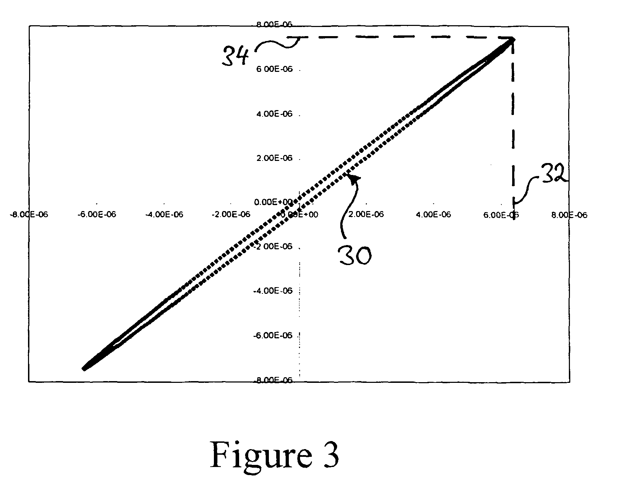

In Figure 3, the graph 30 shows a phase to earth fault on phase 1. Compared to graph 20 of Figure 2, the peak horizontal and vertical magnetic fields 32 and 34 respectively have increased as shown below:
*i*₁=51.67cos(wt) *i*₂=4.41cos(wt+101°) *i*₃=4.41cos(wt-101°) Bₓₘₐₓ=6.35µT, B_{ymax}=7.42µT

| | Pre-fault | Fault | Fault: pre-fault ratio |
|---|---|---|---|
| Bₓₘₐₓ, 32 | 0.33µT | 6.35µT | 19.2 |
| B_{ymax}, 34 | 1.22µT | 7.42µT | 6.08 |

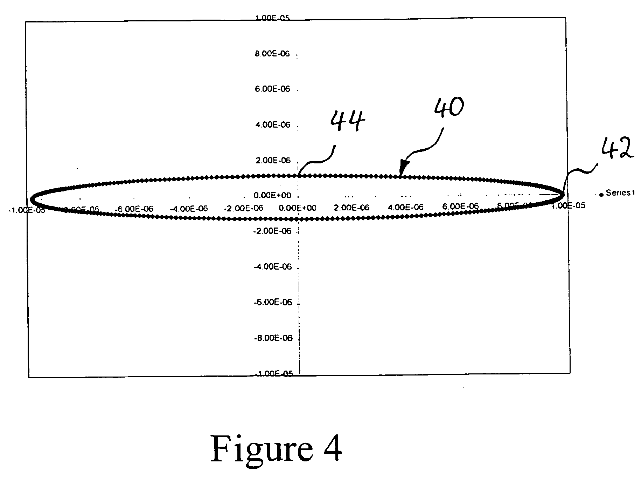

Turning now to Figure 4, the graph 40 shows a phase to earth fault on phase 2. Compared to graph 30 of Figure 2, the peak horizontal magnetic field 42 has increased but the peak vertical magnetic field 44 has not changed. If one was only measuring the vertical magnetic field, the fault current would not be detected:
*i*₁=4.41cos(wt+19.1°) *i*₂=51.67cos(wt-2π/3)
*i*₃=4.41cos(wt-139.1°)
Bₓₘₐₓ=9.80µT, B_{ymax}=1.22µT

| | Pre-fault | Fault | Fault: pre-fault ratio |
|---|---|---|---|
| Bₓₘₐₓ, 42 | 0.33µT | 9.80µT | 29.7 |
| B_{ymax}, 44 | 1.22µT | 1.22µT | 1.0 |

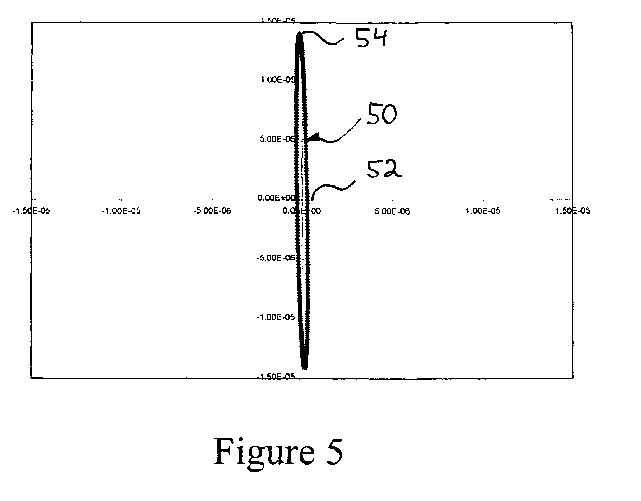

Turning now to Figure 5, the graph 50 shows a phase to phase fault on phases 1 and 3. Compared to graph 30 of Figure 2, the peak vertical magnetic field 54 has increased but the peak horizontal magnetic field 52 has not changed. If only the horizontal magnetic field is measured, the fault current would not be detected:
*i*₁=50cos(wt)+2.5cos(wt+300°) *i*₂=5cos(wt-2π/3)
*i*₃=50cos(wt-π)+2.5cos(wt+300°)
Bₓₘₐₓ=0.33µT, B_{ymax}=14.08µT

| | Pre-fault | Fault | Fault: pre-fault ratio |
|---|---|---|---|
| Bₓₘₐₓ, 52 | 0.33µT | 0.33µT | 1.0 |
| B_{ymax}, 54 | 1.22µT | 14.08µT | 11.54 |

Figures 4 and 5 illustrate the limitations of only measuring one of the horizontal or vertical components of the magnetic field vector.

Use of a single coil at a fixed angle to the horizontal shows similar limitations. This is because there is usually at least one set of fault currents (for one of the conductor configurations in general use) that will produce a change in magnetic field that will not be detectable by the single coil.

A possible solution is to mount the magnetic field sensing point A away from the axis of the middle conductor. This is troublesome in practice, requiring special mounting equipment and calculation of the optimum position for each conductor configuration.

The measurement of both vertical and horizontal magnetic fields removes the limitations found above, and decreases the possibility of missing the passage of fault current.

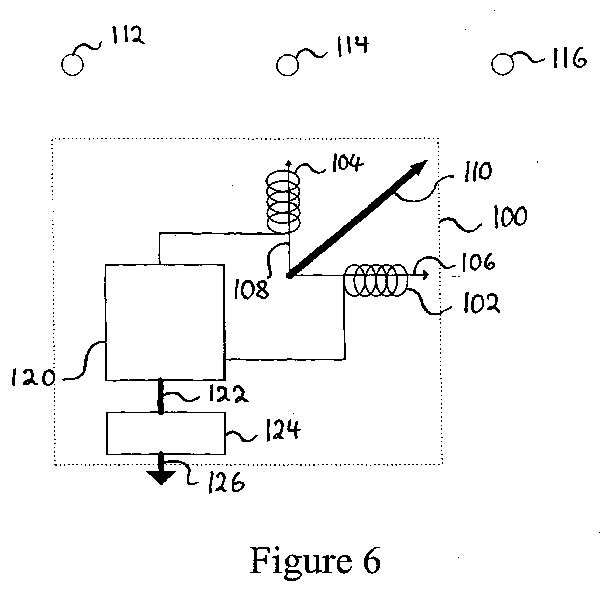

Turning now to Figure 6, a device 100 embodying the present invention comprises two coils 102 and 104 to measure the horizontal and vertical components 106, 108 respectively of a magnetic field vector 110 indicative of the magnetic field around an arrangement of three conductors 112, 114 and 116 at a location along the conductors.

The device 100 further comprises a detecting unit 120 for detecting analogue voltage signals derived from the coils 102, 104. The detecting unit 120 generates signals 122 indicative of the waveforms of the components 106 and 108 respectively.

In the monitoring unit 124, a fault detection signal 126 can be generated depending on changes in the waveforms.

Changes in the waveforms can be indicative of the occurrence of faults on one or more of the conductors 110, 114 and 116, as illustrated in the example scenarios of Figures 2 to 5. For example changes in the parameters measured for the waveforms of the components 106 and 108, such as e.g. their amplitudes, phase difference, harmonic content etc., over a period of the alternating current in the conductors 110, 114, and 116 may be utilised. Alternatively, the waveforms of the components 106 and 108 may be compared with reference data stored in a database (not shown).

The embodiment described above utilises two coils to measure the horizontal and vertical components of the magnetic field vector. The direction of the component measured is determined by the central axis of the coils. It will be appreciated by a person skilled in the art that the present invention is not limited to the measurement of the horizontal and vertical components, but rather any two components may be measured, provided that the components are angularly displaced. It is advantageous that the angle between the components is 90°.

It will also be appreciated by a person skilled in the art that the present invention is not limited to the use of two coils for measuring the respective components of the magnetic field vector. The measurements may be performed utilising a movable coil which can be angularly displaced to perform sequences of measurements for the respective components.

In the claims that follow and in the summary of the invention, except where the context requires otherwise due to express language or necessary implication, the word "comprising" is used in the sense of "including", i. e. the features specified may be associated with further features in various embodiments of the invention.

## Claims

1. A method of detecting for a fault on one of a plurality of adjacent, alternating current carrying conductors (10, 12, 14; 112, 114, 116); the method comprising the steps of:
- detecting the waveform, particularly the amplitude and the phase, of a first component of a magnetic field vector representative of the magnetic field around the plurality of conductors (10, 12, 14; 112, 114, 116) at a location along the conductors (10, 12, 14; 112, 114, 116);
- detecting the waveform, particularly the amplitude and the phase, of a second component of a magnetic field vector;
- monitoring, at the location, the two waveforms for any change in the waveforms, particularly the amplitudes and the phases; and
- detecting for a fault on one of the plurality of conductors (10, 12, 14; 112, 114, 116) as indicated by a change in either one or both of the waveforms, particularly the amplitudes and the phases.

2. A method as claimed in claim 1, further comprising the step of determining whether the fault experienced is a phase to phase or a phase to earth fault as indicated by the change in either one or both of the waveforms, particularly the amplitudes and the phases.

3. A method as claimed in claim 1, wherein the first and second components are at 90° with respect to each other.

4. A method as claimed in claim 1, wherein the first component is the horizontal component of the magnetic field vector and the second component is the vertical component of the magnetic field vector.

5. A method as claimed in claim 1, wherein the step of monitoring the two waveforms comprises the step of monitoring a phase difference between the first and the second waveforms, and the step of detecting for a fault comprises detecting for the fault indicated by a change in the phase difference.

6. An apparatus for detecting for a fault on one of a plurality of adjacent, alternating current carrying conductors (10, 12, 14; 112, 114, 116), the apparatus comprising
- first detecting means (102) for detecting the waveform, particularly the amplitude and the phase, of a first component of a magnetic field vector representing the magnetic field around the plurality of the conductors (10, 12, 14; 112, 114, 116) at a location along the conductors (10, 12, 14; 112, 114, 116);
- second detecting means (104) for detecting the waveform, particularly the amplitude and the phase, of a second component of the magnetic field vector;
- monitoring means (124) for monitoring the two waveforms for any change in the waveforms, particularly the amplitudes and the phases; and
- a detecting unit (120) arranged to generate a fault indication signal (126) depending on a change in either one or both of the waveforms, particularly the amplitudes and the phases.

7. An apparatus as claimed in claim 6, wherein the detecting unit (120) is further arranged to determine whether the fault experienced is a phase to phase or a phase to earth fault depending on reference data stored in a database of the apparatus.

8. An apparatus as claimed in claim 6, wherein the monitoring unit (124) is further arranged to monitor a phase difference between the first and second waveforms, and the detecting unit (120) is arranged to generate the fault indication signal (126) depending on the phase difference.

## Patentansprüche

1. Verfahren zum Detektieren eines Fehlers an einem von einer Vielzahl von benachbarten, wechselstromführenden Leitern (10, 12, 14; 112, 114, 116), wobei das Verfahren die folgenden Schritte aufweist:
- Detektieren der Wellenform, insbesondere der Amplitude und der Phase, einer ersten Komponente eines Magnetfeldvektors, der für das Magnetfeld um die Vielzahl von Leitern (10, 12, 14; 112, 114, 116) herum an einer Stelle entlang der Leiter (10, 12, 14; 112, 114, 116) repräsentativ ist;
- Detektieren der Wellenform, insbesondere der Amplitude und der Phase, einer zweiten Komponente des Magnetfeldvektors;
- Vor-Ort-Überwachen der zwei Wellenformen in Bezug auf eine Änderung der Wellenformen, insbesondere der Amplituden und der Phasen; und
- Detektieren eines Fehlers an einem von der Vielzahl von Leitern (10, 12, 14; 112, 114, 116) entsprechend einer Anzeige durch eine Änderung entweder von einer Wellenform oder von beiden Wellenformen, insbesondere der Amplituden und der Phasen.

2. Verfahren nach Anspruch 1, das ferner den folgenden Schritt aufweist:
Bestimmen, ob der aufgetretene Fehler ein Phase-Phase- oder ein Phase-Erde-Fehler ist entsprechend einer Anzeige durch die Änderung entweder von einer Wellenform oder von beiden Wellenformen, insbesondere der Amplituden und der Phasen.

3. Verfahren nach Anspruch 1, wobei die erste und die zweite Komponente unter einem Winkel von 90° zueinander stehen.

4. Verfahren nach Anspruch 1, wobei die erste Komponente die horizontale Komponente des Magnetfeldvektors ist und die zweite Komponente die vertikale Komponente des Magnetfeldvektors ist.

5. Verfahren nach Anspruch 1, wobei der Schritt des Überwachens der zwei Wellenformen den folgenden Schritt aufweist: Überwachen einer Phasendifferenz zwischen der ersten und der zweiten Wellenform, und der Schritt des Detektierens eines Fehlers umfasst: Detektieren des Fehlers, der durch eine Änderung in der Phasendifferenz angezeigt wird.

6. Vorrichtung zum Detektieren eines Fehlers an einem von einer Vielzahl von benachbarten, wechselstromführenden Leitern (10, 12, 14; 112, 114, 116), wobei die Vorrichtung Folgendes aufweist:
- eine erste Detektiereinrichtung (102) zum Detektieren der Wellenform, insbesondere der Amplitude und der Phase, einer ersten Komponente eines Magnetfeldvektors, der für das Magnetfeld um die Vielzahl der Leiter (10, 12, 14; 112, 114, 116) herum an einer Stelle entlang der Leiter (10, 12, 14; 112, 114, 116) repräsentativ ist; eine zweite Detektiereinrichtung (104) zum Detektieren der Wellenform, insbesondere der Amplitude und der Phase, einer zweiten Komponente des Magnetfeldvektors;
- eine Überwachungseinrichtung (124) zum Überwachen der zwei Wellenformen in Bezug auf eine Änderung der Wellenformen, insbesondere der Amplituden und der Phasen; und
- eine Detektiereinheit (120), die so angeordnet ist, dass sie ein Fehleranzeigesignal (126) in Abhängigkeit von einer Änderung entweder von einer Wellenform oder von beiden Wellenformen, insbesondere der Amplituden und der Phasen, erzeugt.

7. Vorrichtung nach Anspruch 6, wobei die Detektiereinheit (120) (ferner so angeordnet ist, dass sie in Abhängigkeit von Referenzdaten, die in einer Datenbank der Vorrichtung gespeichert sind, bestimmt, ob der aufgetretene Fehler ein Phase-Phase- oder ein Phase-Erde-Fehler ist.

8. Vorrichtung nach Anspruch 6, wobei die Überwachungseinheit (124) ferner so angeordnet ist, dass sie eine Phasendifferenz zwischen der ersten und der zweiten Wellenform überwacht, und die Detektiereinheit (120) so angeordnet ist, dass sie in Abhängigkeit von der Phasendifferenz das Fehleranzeigesignal (126) erzeugt.

## Revendications

1. Procédé pour détecter un défaut sur l'un d'une pluralité de conducteurs adjacents, porteurs de courant alternatif (10, 12, 14 ; 112, 114, 116) ; le procédé comprenant les étapes consistant à :
- détecter la forme d'oride, particulièrement l'amplitude et la phase, d'une première composante d'un vecteur de champs magnétique représentatif du champs magnétique autour de la pluralité de conducteurs (10, 12, 14 ; 112, 114, 116) à un emplacement lé long des conducteurs (10, 12, 14 ; 112, 114, 116);
- détecter la forme d'onde, en particulier l'amplitude et la phase, d'une seconde composante d'un vecteur de champs magnétique ;
- surveiller, à l'emplacement, les deux formes d'onde en vue de tout changement dans les formes d'onde, particulièrement les amplitudes et les phases ; et
- détecter un défaut sur l'un de la pluralité de conducteurs (10, 12; 14 ; 112, 114, 116) comme indiqué par un changement de l'une quelconque ou
- des deux formes d'onde, particulièrement des amplitudes et des phases.

2. Procédé selon la revendication 1, comprenant en outre l'étape consistant à déterminer si le défaut subi est un défaut de phase à phase ou de phase à la terre, comme indiqué par le changement de l'une quelconque ou des deux formes d'onde, particulièrement des amplitudes et des phases.

3. Procédé selon la revendication 1, où les première et seconde composantes sont à 90°, l'une par rapport à l'autre.

4. Procédé selon la revendication 1, où la première composante est la composante horizontale du vecteur de champs magnétique, et la seconde composante est la composante verticale du vecteur de champs magnétique.

5. Procédé selon la revendication 1, où l'étape de surveillance des deux formes d'onde comprend l'étape consistant à surveiller une différence de phase entre les première et seconde formes d'onde, et l'étape de détection d'un défaut comprend la détection du défaut indiqué par un changement dans la différence de phase.

6. Appareil pour détecter un défaut sur l'un d'une pluralité de conducteurs adjacents, porteurs de courant alternatif (10, 12, 14 ; 112, 114, 116), l'appareil comprenant :
- un premier moyen de détection (102) pour détecter la forme d'onde, particulièrement l'amplitude et la phase, d'une première composante d'un vecteur de champs magnétique représentant le champs magnétique autour de la pluralité de conducteurs (10, 12, 14 ; 112, 114, 116) à un emplacement le long des conducteurs (10, 12, 14 ; 112, 114, 116) ;
- un second moyen de détection (104) pour détecter la forme d'onde, particulièrement l'amplitude et la phase, d'une seconde composante du vecteur de champs magnétique ;
- un moyen de surveillance (124) pour surveiller les deux formes d'onde en vue de tout changement dans les formes d'onde, particulièrement les amplitudes et les phases ; et
- une unité de détection (120) agencée pour produire un signal d'indication de défaut (126) en fonction d'un changement dans l'une quelconque ou les deux formes d'onde, particulièrement les amplitudes et les phases.

7. Appareil selon la revendication 6, où l'unité de détection (120) est agencée en outre pour déterminer si le défaut subi est un défaut de phase à phase ou un défaut de phase à la terre en fonction des données de référence stockées dans une base de données de l'appareil.

8. Appareil selon la revendication 6, où l'unité de surveillance (124) est agencée en outre pour surveiller une différence de phase entre les première et seconde formes d'onde, et l'unité de détection (120) est agencée pour produire le signal d'indication de défaut (126) en fonction de la différence de phase.
